**Europäisches Patentamt**

**European Patent Office**

**Office européen des brevets**

(11) Numéro de publication : **0 410 903 B1**

(12) **FASCICULE DE BREVET EUROPEEN**

(45) Date de publication du fascicule du brevet :
27.10.93 Bulletin 93/43

(51) Int. Cl.⁵ : **B32B 27/36, G03F 7/11**

(21) Numéro de dépôt : **90420338.7**

(22) Date de dépôt : **13.07.90**

(54) **Films polyesters composites et leur utilisation comme couche de protection pour plaques photopolymères et plaques photopolymères les comportant.**

Jointe à la demande no. 90911298.9/0484388 (numéro de dépôt/numéro de publication de la demande européenne) par décision du 17.07.92.

(30) Priorité : **27.07.89 FR 8910389**

(43) Date de publication de la demande :
**30.01.91 Bulletin 91/05**

(45) Mention de la délivrance du brevet :
**27.10.93 Bulletin 93/43**

(84) Etats contractants désignés :
**AT BE CH DE DK ES FR GB GR IT LI LU NL SE**

(56) Documents cités :
**EP-A- 0 091 693**
**WO-A-86/06024**
**FR-A- 2 229 112**
**PATENT ABSTRACTS OF JAPAN vol. 9, no. 299 (P-408)(2022) 27 novembre 1985**
**PATENT ABSTRACTS OF JAPAN vol. 6, no. 198 (P-147)(1076) 07 octobre 1982**

(73) Titulaire : **RHONE-POULENC FILMS**
**25, quai Paul Doumer**
**F-92408 Courbevoie (FR)**

(72) Inventeur : **Assante, Jean-Pierre**
**15 rue Galilée**
**F-69100 Villeurbanne (FR)**
Inventeur : **Corsi, Philippe**
**La Duchère 336 C Balmont-Ouest**
**F-69009 Lyon (FR)**
Inventeur : **Veyrat, Didier**
**21 rue de Nervieux**
**F-69450 St-Cyr-Au-Mont-D'or (FR)**

(74) Mandataire : **Vignally, Noel et al**
**Rhône-Poulenc Chimie Direction de la Propriété Industrielle Centre de Recherches des Carrières B.P. 62**
**F-69192 Saint-Fons Cédex (FR)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

Jouve, 18, rue Saint-Denis, 75001 PARIS

## Description

La présente invention a pour objet de nouveaux films polyester composites ayant des propriétés de surface particulières et leur utilisation comme couche de protection pour plaques photopolymères.

On sait que les éléments photosensibles tels que les plaques photopolymères utilisées pour préparer des plaques d'impression et en particulier des plaques d'impression flexographique sont constituées par au moins un ensemble comportant une couche d'un polymère photopolymérisable déposée entre un support et un film de protection. En général le support et le film de protection consistent en un film métallique ou en films ou feuilles de polymères thermoplastiques filmogènes. Les films polyester, et en particulier les films polyester orientés comportant une pluralité de motifs dérivés du téréphtalate d'alkylène constituent un matériau de choix pour la réalisation desdits supports ou films de protection pour éléments photosensibles. Le film de protection a pour premier rôle de protéger la couche photopolymère contre les détériorations qu'elle pourrait subir au cours des manipulations et/ou du stockage des éléments photopolymérisables ; il joue encore le rôle de séparateur lors de l'empilement des plaques photopolymérisables. Le film protecteur est séparé de la couche photopolymérisable au moment de l'utilisation des éléments photopolymérisables. Il s'est avéré avantageux lors de cette utilisation de conférer à la couche photopolymérisable une topographie de surface permettant un placage le plus complet possible de la surface d l'élément sur la plaque de verre des machines d'impression et/ou sur la surface des négatifs.

Un tel objectif ne peut être atteint rapidement que si l'air emprisonné entre la couche photopolymérisable et la plaque de verre peut s'échapper aisément lors de la mise en place de l'élément polymérisable c'est-à-dire si la couche photopolymérisable présente une rugosité suffisante. Cette rugosité peut lui être avantageusement communiquée par le film de protection par effet report si la surface de celui-ci en contact avec la couche photopolymérisable comporte une pluralité de protubérances ayant sensiblement la même hauteur et réparties de manière régulière à la surface du film protecteur en contact avec la couche photopolymérisable. En outre pour certaines applications (fabrication de plaques offset par exemple) pour lesquelles la couche photopolymérisable est particulièrement mince (son épaisseur peut être d'environ 3 μm) il convient de veiller à ce que la surface rugueuse du film de protection soit exempte de pics provoquant la perforation de la couche photopolymérisable. La réalisation de films polyester présentant de telles propriétés de surface passe par l'utilisation de charges répondant à des exigences particulières relativement à leur dimension particulaire, à la distribution de la taille des particules, à leur aptitude à ne pas se réagglomérer lors de leur introduction dans le polyester. Généralement de telles charges sont introduites dans toute l'épaisseur du film protecteur (film dit pleine masse) ; une partie des charges ne participant pas à l'obtention du résultat recherché est alors consommée en pure perte. Par ailleurs l'utilisation d'une concentration en charge élevée dans toute l'épaisseur du film contribue à rendre ce dernier opaque, ce qui ne permet pas de voir la couche photopolymérisable à travers la couche de protection. Enfin les déchets de films pleine masse à concentration élevée en charges sont difficiles sinon impossible à recycler.

Un premier objectif de la présente invention réside dans la mise au point d'un film protecteur rugueux, de topographie régulière apte à communiquer sa rugosité à une couche photopolymérisable.

Un second objectif de la présente invention réside dans la mise au point d'un film protecteur rugueux exempt de pics susceptibles de provoquer la perforation des couches photopolymères les plus minces.

Un troisième objectif de la présente invention consiste à obtenir un film protecteur rugueux comportant une concentration élevée de charges monodisperses en limitant la quantité de charge mise en oeuvre. Un quatrième objectif de la présente invention réside dans l'obtention de films protecteurs rugueux à transparence aussi élevée que possible compte-tenu de la concentration en charge.

Plus précisément la présente invention a pour objet de nouveaux films polyester composites biorientés semi-cristallins comportant une couche polyester épaisse A chargée ou non chargée et sur au moins une des faces de la couche A, une couche polyester B coextrudée d'épaisseur inférieure à celle de la couche A caractérisés en ce que la couche B présente les caractéristiques de surface suivantes :
- rugosité totale (hauteur pic/vallée) $Rt \leqq 3 \ \mu m$
- densité de pics exprimée par le rapport $Rt/Ra \leqq 10$ (Ra étant la rugosité moyenne arithmétique) et contient de 5 à 35 % en poids d'une charge présentant les caractéristiques suivantes :
  . diamètre moyen 1,5 à 2,5 μm
  . monodispersité : $I = D\ 75 - D\ 25 \leqq 1,2$

De préférence la densité de pics des films selon l'invention est comprise entre 5 et 9.

Dans la demande internationale publiée sous le n° WO 86/06024, on a décrit des films composites en polyester constitués par une couche épaisse non chargée (A) et au moins une couche mince chargée (B) destinés à la fabrication de formes imprimantes pour l'obtention de plaques offset notamment. En raison de cette destination, ces films composites doivent répondre à des exigences strictes concernant d'une part leur rugosité, qui doit être suffisante pour assurer une bonne machinabilité et une bonne séparation des feuilles dans les rames de reproduction, et d'autre part leur transparence. Ces exigences contradictoires ont été conciliées en introduisant de faibles quantités (0,01 à 1 % en poids) de charges et en réglant l'épaisseur de la couche chargée (B) en fonction de l'épaisseur de la couche non chargée (A). La mise au point de films composites en polyester destinés à la fabrication de feuilles de protection pour éléments photosensibles à couche photosensible rugueuse, qui doivent répondre à d'autres exigences de leur topographie de surface (rugosité totale inférieure à l'épaisseur des couches photosensibles, forte densité de pics de hauteur régulière), passe par l'adoption de solutions techniques différentes (fortes teneurs en charges à monodispersité élevée).

Les polyesters utilisés pour l'obtention des couches (A) et (B) des films composites coextrudés selon l'invention sont ceux auxquels on fait appel habituellement pour l'obtention de films semi-cristallins bi-orientés. Il s'agit de polyesters linéaires filmogènes, cristallisables par orientation et obtenus de façon usuelle à partir d'un ou plusieurs acides aromatiques dicarboxyliques ou leurs dérivés (esters d'alcools aliphatiques inférieurs, halogénures par exemple) et d'un ou plusieurs glycols aliphatiques. Comme exemple de diacides aromatiques, on peut citer les acides phtalique, téréphtalique, isophtalique, naphtalènedicarboxylique-2,5 ; naphtalène-dicarboxylique-2,6. Ces acides peuvent être associés à une quantité mineure d'un ou plusieurs acides dicarboxyliques aliphatiques tels que les acides adipiques, azélaïque, hexahydrotéréphtalique. Comme exemples non limitatifs de diols aliphatiques, on peut citer l'éthylèneglycol ; le propanediol-1,3 ; le butanediol-1,4. Ces diols peuvent être associés à une quantité mineure d'un ou plusieurs diols aliphatiques plus condensés en carbone (néopentylglycol par exemple) ou cycloaliphatiques (cyclohexanediméthanol). Préférentiellement, les polyesters filmogènes cristallisables sont des polytéréphtalates ou des polynaphtalènedicarboxylates d'alkylènediols et, en particulier, le polytéréphtalate d'éthylèneglycol (PET) ou de butanediol-1,4 ou des copolyesters comportant au moins 80 % en moles de motifs téréphtalate ou naphtalènedicarboxylates d'alkylèneglycols. Avantageusement, le polyester est un polytéréphtalate d'éthylèneglycol dont la viscosité intrinsèque mesurée à 25°C dans l'o-chlorophénol est comprise entre 0,6 et 0,75 dl/g.

Afin d'obtenir une répartition régulière de pics de hauteur sensiblement identique à la surface des films selon l'invention on fait appel à des charges monodisperses c'est-à-dire à des charges caractérisées par un indice de monodispersité $I = D\,75 - D\,25$ inférieur ou égal à 1,2 et qui pourrait être égal à zéro. Les termes $D\,75$ et $D\,25$ seront définis ultérieurement. Le diamètre moyen $D\,50$, défini comme le diamètre d'une particule sphérique correspondant à 50 % du poids de l'ensemble des particules lu sur la courbe de distribution cumulée reliant le pourcentage pondéral au diamètre des particules est compris entre 1,5 et 2,5 $\mu$m et de préférence entre 1,8 $\mu$m et 2,2 $\mu$m.

La nature des charges n'est pas critique pour autant qu'elles répondent aux exigences de monodispersité et de diamètre moyen indiqué ci-avant. On peut donc faire appel à des charges de nature variée : sels métalli-ques ($CaCO_3$ ; $BaSO_4$) ; métalliques : $SiO_2$, $TiO_2$, $ZrO_2$, $Al_2O_3$, mélanges silice/alumines, silicates. Cependant il est préférable de faire appel à des charges qui ne se réagglomèrent peu ou pas lors de leur introduction dans le polymère. On fait appel de préférence aux oxydes métalliques obtenus par hydrolyse d'un alcoolate métallique tels que les silicates, les titanates, les zirconates, les aluminates d'alkyle en milieu hydroalcolique, en présence d'une base alcaline (en particulier l'ammoniaque) selon le procédé décrit par W. STÖEBER et al J. Colloïd and Interface Sci 26 (1968) 62-69 ; brevet américain 3 634 558 et dans la demande de brevet européen 0 234 945. Les oxydes métalliques obtenus de cette façon se présentent sous forme de particules sphériques monodisperses. Les oxydes sphériques monodispersés et en particulier les silices obtenues par hydrolyse alcaline en milieu hydroalcoolique des silicates d'alkyle (silicates de méthyle, d'éthyle, de n-propyle, d'isopropyle) conviennent tout particulièrement bien ; les particules de silice peuvent éventuellement avoir subit un traitement d'estérification de tout ou partie des groupes silanols présents à leur surface, selon le procédé décrit dans le brevet américain de K. ILER N° 2 801 185 et par A.K. VAN HELDEN et al., J. Colloïd Interface Sci 81 (1981) p. 354-367, au moyen d'alcools ou de polyols tels que l'éthylèneglycol. Les oxydes métalliques sphériques monodisperses peuvent être introduits dans le polyester par les procédés usuels c'est-à-dire lors de la réaction d'interéchange ou de la polycondensation, sous forme de poudre ou, de préférence sous forme d'une suspension glycolique (cf demande brevet européen 0 236 945) ou par la technique des mélanges maîtres.

Par particules sphériques on désigne au sens de la présente invention des particules dont le coefficient de forme $\phi v$ est compris entre 0,45 et 0,523, $\phi v$ étant égal au rapport $V/D^3$ du volume V de la particule exprimé en $\mu$m³ au diamètre maximum des particules.

La quantité de charge introduite dans la couche B dépend de la nature de la charge et en particulier de sa densité. En effet la densité de pics dépend directement du nombre de particules de charges présentes dans le polymère. Pour un poids de charge donné et un diamètre moyen déterminé le nombre de particules est d'autant plus élevé que la densité de la charge est plus faible. D'une façon générale la quantité de charge est comprise entre 5 et 35 % en poids et de préférence entre 5 et 25 % en poids du polymère. Dans le cas où l'on fait appel à de la silice monodisperse comme charge une quantité comprise entre 5 et 15 % en poids convient bien.

La quantité adéquate de charge peut être déterminée dans chaque cas particulier au moyen d'essais simples pour communiquer à la couche (aux couches) (B) une densité de pics, exprimée par le rapport Rt/Ra, inférieure ou égale à 10.

Les films composites selon la présente invention comportent au moins une couche B telle que définie ci-avant. Dans le cas où ils sont utilisés comme couche de protection dans des éléments photopolymérisables multicouches ils peuvent comporter une couche B sur chaque face ; le film composite ainsi constitué joue alors le rôle d'intercalaire et de feuille de protection entre les couches photopolymérisables de deux éléments. Selon une variante les films composites conformes à l'invention et ne comportant qu'une seule couche B peuvent jouer à la fois le rôle de film protecteur et le rôle de support permanent dans des éléments photopolymérisables multicouches. Dans ce cas la face portant la couche B vient en contact avec une face de la couche photopolymérisable d'un élément, et l'autre face du film composite comportant le cas échéant un revêtement adhésif de type connu est en contact avec la couche photopolymérisable d'un autre élément. On peut ainsi associer une pluralité d'éléments photopolymérisables.

Lorsque le film selon l'invention est destiné à jouer le double rôle de support et de feuille de protection la face de la couche A ne comportant pas de couche B conforme à l'invention peut être pourvue par tout moyen approprié (coextrusion, enduction en ligne, enduction en reprise) d'une couche d'un primaire d'adhérence de type connu. A cet effet on peut utiliser des polymères acryliques ou des copolyesters comportant une pluralité de groupes oxysulfonyles ($SO_3M$, M représentant un atome d'hydrogène ou un atome de métal alcalin ou alcalino-terreux) : cf. demandes de brevets européens publiées sous les n° 0 267 856 ; 0 275 801 ; 0 272 993 ; demande de brevet français 88/03302 publiée sous le N° 2 628 359 ou des copolyesters à groupes oxysulfonyles greffés tels que ceux décrits dans la demande de brevet européen publiée sous le N° 0 260 203.

Les films composites coextrudés selon la présente invention sont obtenus par l'extrusion simultanée d'un polyester A ne contenant pas de charges ou contenant le cas échéant des charges différentes de celles de la couche B, et d'un polyester B contenant la charge sphérique monodisperse décrite ci-avant.

A cet effet, on extrude à l'aide d'une première extrudeuse un flux (A) de polyester cristallisable et, simultanément, à l'aide d'une deuxième extrudeuse un flux du polyester (B) destiné à former la ou les couches (B). Les deux extrudeuses sont reliées à une boîte de coextrusion dans laquelle le flux (B) peut être, le cas échéant, divisé en deux flux (B). Les courants de polymères fondus sont transformés en un film amorphe multicouche par passage dans une filière plate et le film amorphe ainsi obtenu est soumis aux opération usuelles de filmature : trempe, étirage thermofixation et bobinage.

Les conditions de filmature sont celles mises en oeuvre habituellement industriellement pour l'obtention de films polyesters semicristallins orientés. Au sortir de la filière, le film composite amorphe est refroidi à une température comprise entre 10°C et 45°C sur un tambour de coulée.

Les conditions d'étirage du film composite extrudé sont celles habituellement mises en oeuvre dans la fabrication des films polyester semi-cristallins. Ainsi, on peut procéder à un monoétirage ou à un biétirage effectué successivement ou simultanément dans deux directions en général orthogonales ou encore par séquences d'au moins 3 étirages où la direction d'étirage est changée à chaque séquence. Par ailleurs, chaque étirage monodirectionnel peut lui-même être effectué en plusieurs étapes. On pourra ainsi associer des séquences d'étirage comme par exemple deux traitements successifs de biétirage, chaque étirage pouvant être effectué en plusieurs phases.

De préférence, le film composite est soumis à un biétirage dans deux directions perpendiculaires. On peut, par exemple, procéder d'abord à un étirage dans la direction de déplacement du film (étirage longitudinal) puis à un étirage selon une direction perpendiculaire (étirage transversal) ou inversement. En général, l'étirage longitudinal est effectué à un taux de 3 à 5 (c'est-à-dire que la longueur du film étiré représente de 3 à 5 fois la longueur du film amorphe) et à une température de 80 à 135°C et l'étirage transversal est effectué avec un taux de 3 à 5 à une température de 90 à 135°C et de préférence entre 100 et 125°C.

Après étirage le film composite est soumis à un traitement thermique à une température comprise entre 160 et 240°C.

L'étirage peut également être effectué de manière simultanée, c'est-à-dire à la fois dans le sens longitudinal et dans le sens transversal, par exemple avec un taux d'étirage de 3 à 5 et à une température de 80 à 120°C.

Le débit des extrudeuses dépend des épaisseurs des couches (A) et (B) après étirage. La couche (A) a généralement une épaisseur comprise entre 20 µm et 150 µm et, de préférence entre 30 µm et 100 µm. L'épaisseur de la (ou des) couche(s) (B) est généralement inférieure au diamètre moyen des particules de la charge monodisperse. De préférence cette épaisseur est comprise dans un intervalle de 0,5 µm à 2 µm.

Les films composites selon l'invention présentent avantageusement un taux de retrait libre dans les deux directions à 150°C inférieur ou égal à 2 % et de préférence inférieur ou égal à 1,5 %.

Bien qu'il soit préférable que la couche A ne contienne pas de charge, il peut s'avérer utile, en particulier lorsque le film composite ne comporte qu'une couche (B), de lui conférer une rugosité suffisante pour en faciliter le bobinage par introduction d'une charge usuelle. Dans ce cas les charges incorporées dans la couche A ont de préférence un diamètre moyen inférieur ou égal à celui des charges de la couche A et la quantité de charge est inférieure à celle de la couche B. En général celle quantité est inférieure à 5 % en poids et se trouve comprise entre 0,1 et 3 % en poids. Cet objectif pourrait être atteint par mise en place sur la face de (A) opposée à la couche (B) d'une couche (C) contenant une quantité adéquate d'une charge usuelle différente de celle de la couche (B).

Lorsque les films composites selon l'invention comportent deux couches (B) il n'est pas nécessaire que la couche (A) contienne une charge, mais on ne sortirait pas du cadre de l'invention en introduisant dans la couche (A) une charge usuelle différente de la charge monodisperse des couches (B).

Les films selon la présente invention dont la couche (A) est exempte de charge présente une turbidité inférieure à 80 %. Toutes choses égales par ailleurs un film pleine masse est totalement opaque.

Les films composites selon l'invention conviennent tout particulièrement bien comme films de protection d'éléments photopolymérisables pour la fabrication de plaques d'impression notamment par le procédé d'impression flexographique. Cette utilisation constitue un second objet de la présente invention.

Un troisième objet de la présente invention réside dans des éléments photopolymérisables pour plaque d'impression constitués par au moins un ensemble comprenant essentiellement un support, une couche photopolymérisable et un film protecteur, caractérisés en ce que ledit film protecteur consiste en un film polyester composite biorienté coextrudé comportant une couche épaisse (A) contenant ou non une charge et, sur au moins une des faces de ladite couche (A), une couche polyester (B) d'épaisseur inférieure à celle de la couche (A) présentant les caractéristiques de surface suivantes :

- $Rt \leq 3\ \mu m$
. densité de pics : $Rt/Ra \leq 10$

ladite couche (B) contenant une charge ayant les caractéristiques suivantes :

. diamètre moyen : 1,5 $\mu m$ à 2,5 $\mu m$
. monodispersité : $I \leq 1,2$

Dans les éléments photopolymérisables selon la présente invention le support et la couche polymérisable sont ceux utilisés habituellement, (cf. brevets américains 2,948, 611 3 024 180 ; 4 323 637 ; Research Disclosure 86/188 103). Le support permanent de la couche photopolymérisable peut être constitué par tout matériau en feuille, film ou plaque. Ainsi on peut faire appel à des films, des feuilles, des plaques métalliques (aluminium par exemple) ou à base de polymères filmogènes (polymères ou copolymères vinylique ; polyesters, polyamides, polyimides, polyesteramides) Les films, feuilles ou plaques de polyester conviennent tout spécialement bien. Le support permanent peut comporter le cas échéant une couche d'un adhésif destiné à améliorer sa liaison à la couche photopolymérisable.

Les éléments photopolymérisables conformes à la présente invention peuvent être constitués par un ou plusieurs ensembles composés essentiellement par un support permanent, une couche photopolymérisable et un film protecteur selon l'invention. Comme celà a été exposé ci-avant, dans un élément composé de deux ensemble photopolymérisables, le film protecteur comporte une couche (B) sur chaque face et joue le rôle d'intercalaire entre 2 couches photopolymérisables de deux éléments. Dans les éléments comportant plus de deux ensembles le film protecteur est constitué par la face du support de l'ensemble adjacent portant une couche (B).

Les exemples qui suivant, donnés à titre non limitatif, illustrent l'invention et montrent comment elle peut être mise en pratique. Les propriétés des charges et des films composites sont définies ci-après et leurs méthodes de mesure sont décrites.

A) Caractéristiques des films :

1° - Rugosités

a) Ecart moyen arithmétique : rugosité Ra (ou CLA)
Cette caractéristique définie dans la norme DIN 4.768 a été mesurée sur un appareil PERTHEN S6P® conformément à la méthode décrite dans cette norme, dans les conditions suivantes :
- valeur de la longueur d'onde de coupure (cut-off) : 0,08 mm,
- longueur de palpage 1,75 mm
- rayon de courbure du palpeur : 4 $\mu m$
- force d'appui du palpeur : 50 mg.f
Le résultat retenu est la moyenne de 30 mesures effectuées sur des profils distants de 20 $\mu m$.
b) Rugosité totale Rt (hauteur pic/vallée) mesurée dans les mêmes conditions que Ra.

2° - <u>Densité de pics</u>

Elle est exprimée par le rapport Rt/Ra, mesurés comme décrit précédemment.

3° - <u>Retrait à 150°C</u>

Des éprouvettes circulaires de diamètre 100 mm sont découpées dans un film polyester aprés repérage des sens de l'étirage transversal et de l'étirage longitudinal du film. Les éprouvettes sont ensuite portées à 150°C pendant 30 mn dans une étuve ventilée thermostatée. Après refroidissement, les diamétres des éprouvettes sont déterminés dans le sens transversal (DT) et dans le sens longitudinal (DL) au moyen d'un bloc de mesure constitué par une échelle de mesure graduée par 0,1 mm gravée sur une plaque de verre éclairée et par une lunette de visée. Le retrait est exprimé et calculé au moyen des formules :
- RT = 100 - DT
- RL = 100 - DL

4° - <u>Turbidité</u> :

Le pourcentage de lumière dipersée transmise (ou "haze") caractérise la turbidité des films. Sa détermination est effectuée selon la norme ASTM D 100.

B - <u>Caractéristiques des charges de la couche B</u>

1° - Diamètre moyen des particules D 50 défini précédemment : il est mesuré à l'aide d'un granulomètre à laser de marque commerciale SYMPATEC® dans une solution aqueuse de pyrophosphate de sodium.

2° - D 75 et D 25, qui représentent respectivement le diamètre d'une particule sphérique correspondant à 75 et 25 % en poids de l'ensemble des particules lu sur la courbe de distribution cumulée reliant le pourcentage pondéral de particules à leur diamètre, sont mesurés de la même façon que D 50.

<u>EXEMPLE 1 -</u>

a) <u>Préparation d'un mélange maître</u>

On prépare un mélange maître constitué par 85 % en poids d'un polytéréphtalate d'éthylèneglycol exempt de charge, d'indice de viscosité 740 et par 15 % en poids d'une silice sphérique monodisperse vendu sous marque commerciale MICROBEAD P400® et présentant les caractéristiques suivantes :
. D50 en μm : 1,95
. D25 en μm : 1,55
. D75 en μm : 2,41
. I en μm : 0,86
contenant 0,12 % en poids de particules de diamètre minimum 0,62 μm et 0,98 % en poids de particules de diamètre maximun 4,2 μm, par introduction des constituants dans une extrudeuse à double vis de marque commerciale LEISTRITZ® de diamètre 354 mm et de longueur égale à 35 fois le diamètre et extrusion avec un débit de 10 kg/heure, la pression de dévolatilisation étant de $7 \times 10^3$ Pa et la vitesse de rotation de la vis de 100 t/mn. Le jonc ainsi obtenu est refroidi à l'eau froide puis séché dans un courant d'air chaud et transformé en granulés.

Un mélange maître secondaire contenant 10 % en poids de silice est obtenu en opérant comme ci-avant à partir du même PET non chargé et du mélange maître à 15 % préparé précédemment. L'indice de viscosité du mélange maître secondaire est de 640.

b) <u>Préparation d'un film polyester composite B/A/B -</u>

On prépare un film polyester composite comportant une couche interne A non chargée de 72 μm d'épaisseur et sur chaque face de A une couche B de 1,5 μm d'épaisseur par coextrusion du PET exempt de charge utilisé pour la préparation du mélange maître d'une part et du mélange maître secondaire à 10 % de silice d'autre part, au moyen d'un dispositif comportant deux extrudeuses reliées à une boîte de dérivation divisant le flux (B) de polymère chargé en deux flux secondaires (B).

Le débit de la ligne principale d'extrusion (flux A) est de 120 kg/h et sa température de 280°C. La ligne satellite à un débit de 5 kg/heure, une température comprise entre 265°C et 270°C et la pression d'entrée dans la boîte de dérivation est comprise entre 6 x 10⁶ Pa et 9 x 10⁶ Pa.

Les trois veines B/A/B sont extrudées à travers une filière plate. La masse coextrudée est refroidie par placage sur un tambour de coulée maintenu à 35°C puis le film composite amorphe subit un étirage longitudinal à un taux de 3,24 à une température de 105°C et ensuite un étirage transversal à un taux de 3,27 à une température comprise entre 115°C et 125°C. Le film biétiré subit ensuite un traitement thermique de thermofixation à une température de 230°C pendant 5 sec, puis il est refroidi et bobiné.

Le film ainsi obtenu présente les propriétés suivantes :

1° - Rugosité

. Ra : 0,31 μm

. Rt : 2,38 μm

. Rt/Ra : 7,68

Taux de retrait à 150°C

- sens longitudinal : 0,98 %

- sens transversal : 0,45 %

- Turbidité : 73,7 %


EXEMPLE 2 :


En opérant suivant le procédé de l'exemple 1 on a préparé un film composite de type B/A/B de 75 μm d'épaisseur totale en remplaçant le PET à 10 % de silice par un PET à 7 % de silice obtenu à partir des quantités adéquates de mélange maître à 10 % de silice et de PET non chargé.

On a obtenu un film composite présentant les propriétés suivantes :

1° - Rugosités

. Ra : 0,281 μm

. Rt : 2,36 μm

. Rt/Ra : 8,39

Taux de retrait à 150°C.

- longitudinal : 1,05 %

- transversal : 0,5 %

- Turbidité : 69,7 %


EXEMPLE 3 :


En opérant comme à l'exemple 1 on a préparé un film composite du type B/A/B en remplaçant le PET à 10 % de silice par un PET à 5 % de silice par mélange des quantités adéquates de mélange maître à 10 % de silice et de PET non chargé. Le film obtenu présente les propriétés suivantes :

1° - Rugosités

. Ra : 0,243 μm

. Rt : 1,79 μm

. Rt/Ra : 7,36

Taux de retrait à 150°C

- sens longitudinal : 0,95

- sens transversal : 0,53

- Turbidité : 58,5 %


EXEMPLE 4 :


1° - Préparation d'un polymère à 10 % en poids de silice. Un polytéréphtalate d'éthyléneglycol contenant 10 % en poids de silice sphérique monodisperse de marque commerciale MICROBEAD P400® a été préparé dans un autoclave de 300 litres, à partir de 120 kg de téréphtalate de diméthyle et 93,3 kg d'une suspension de 13,3 kg de silice dans 80 kg l'éthyléneglycol, en présence d'acétate de calcium (175 parties par million), de trioxyde d'antimoine (350 parties par million) et d'acide orthophosphorique (54 parties par million).

Le polymère ainsi obtenu présente une viscosité intrinsèque mesurée sur une solution à 25 % dans l'orthochlorophénol de 80.

2° - préparation d'un film composite.

En opérant comme à l'exemple 1 on a préparé un film composite de type B/A/B par coextrusion d'un polyester non chargé et du polyester chargé obtenu précédemment.

Le film composite ainsi obtenu présente les caractéristiques suivantes :

. Ra : 0,32 µm

. Rt : 2,42 µm

. Rt/Ra : 7,56

. Turbidité : 60 %

## EXEMPLE COMPARATIF 1 :

En opérant comme à l'exemple 1 on a préparé un film composite dont les couche (B) contiennent 2 % en poids de silice MICROBEAD P 400®. Le film obtenu présente les caractéristiques suivantes :

. Ra : 0,126 µm

. Rt : 1,80 µm

. Rt/Ra : 14

. Turbidité : 21

Ce film qui présente une trop faible densité de pics est impropre à l'emploi comme film de protection de plaques photopolymérisables.

## EXEMPLE COMPARATTF 2 :

En opérant comme à l'exemple 1 on a préparé des films composites dont les couches (B) contiennent des quantités variables de sulfate de barium (marque commerciale BLANC FIXE H). Les caractéristiques des films obtenus figurent dans le tableau suivant. Le sulfate de barium présentait les caractéristiques suivantes :

. D50 : 2,04

. D75 : 2,9

. D75 : 2,9

. D25 : 1,36

. I : 1,54

| EX. C | CHARGE | | | FILMS | | | |
|---|---|---|---|---|---|---|---|
| | % en poids | D 50 | I µm | Rt (µm) | Ra µm | Rt/ Ra | turbi-dité |
| 1 | 10 | 2,04 | 1,54 | 2,09 | 0,11 | 19 | 49 |
| 2 | 7 | " | " | 1,88 | 0,087 | 21,5 | 37 |
| 3 | 5 | " | " | 1,46 | 0,063 | 23,17 | 27 |

Les films obtenus de cette façon ne conviennent pas à l'emploi comme film de protection pour plaques photopolymère en raison d'une trop faible densité de pic.

## Revendications

1. Films polyester composites biorientés semi-cristallins comportant une couche polyester épaisse (A) chargée ou non chargée et sur au moins une des faces de la couche (A), une couche polyester (B) coextrudée d'épaisseur inférieure à celle de la couche A, caractérisés en ce que la couche (B) présente les caractéristiques de surface suivantes :

    - rugosité totale (hauteur pic/vallée) Rt $\leqq$ 3 µm
    - densité de pics exprimée par le rapport Rt/Ra $\leqq$ 10 (Ra étant la rugosité moyenne arithmétique) et contient de 5 à 35 % en poids d'une charge présentant les caractéristiques suivantes :
        . diamètre moyen D50 de 1,5 à 2,5 µm
        . monodispersité : I $\leqq$ à 1,2

2. Films polyester composites biorientés semi-cristallins selon la revendication 1, caractérisés en ce que la charge est constituée par des particules d'oxydes métalliques sensiblement sphériques.

3. Films polyester composites biorientés semi-cristallins selon l'une quelconque des revendications 1 à 2, caractérisés en ce que la couche (B) a une épaisseur inférieure au diamètre moyen des particules de la charge qu'elle contient.

4. Films polyester composites biorientés semi-cristallins selon l'une quelconque des revendications 1 à 3, caractérisés en ce que la charge est la silice.

5. Films polyester composites biorientés semi-cristallins selon la revendication 4, caractérisés en ce que la quantité de charge est comprise entre 5 et 15 % en poids du polyester constituant la couche (B).

6. Utilisation des films polyester composites biorientés semi-cristallins selon l'une quelconque des revendications 1 à 5 comme feuilles de protection de la couche photopolymérisable d'un élément photopolymérisable pour plaque d'impression.

7. Eléments photopolymérisables pour plaque d'impression constitués par au moins un ensemble comprenant essentiellement un support, une couche photopolymérisable et un film protecteur, caractérisés en ce que ledit film protecteur consiste en un film polyester composite biorienté coextrudé selon l'une quelconque des revendications 1 à 5.

8. Eléments photopolymérisables selon la revendication 7 comportant deux ensembles comprenant chacun essentiellement un support et une couche photopolymérisable, caractérisés en ce que les deux couches photopolymérisables sont séparées par une feuille de protection constituée par un film polyester composite biorienté semi-cristallin selon l'une quelconque des revendications 1 à 5 et comportant une couche (B) sur chaque face de la couche (A).

9. Eléments photopolymérisables selon la revendication 8, constitués par une pluralité d'ensembles comprenant chacun un support, une couche phtopolymérisable et une feuille de protection, caractérisés en ce que chaque couche photopolymérisable de l'élément est séparée de la couche photopolymérisable adjacente par un film polyester composite selon l'une quelconque des revendications 1 à 5 comportant une couche (B) sur une seule des faces de la couche (A).

10. Eléments photopolymérisables selon la revendication 9, caractérisés en ce que la face de la couche (A) exempte de couche (B) comporte une couche d'un revêtement favorisant l'adhésion à la couche photopolymérisable.


**Patentansprüche**

1. Semikristalline. biorientierte Polyesterfilm-Komposite, umfassend eine beladene oder nicht beladene dicke Polyesterschicht (A) und mindestens auf einer Seite der Schicht (A) eine koextrudierte Polyesterschicht (B) mit geringerer Dicke als die der Schicht (A), dadurch gekennzeichnet, daß die Schicht (B) die folgenden Oberflächencharakteristiken aufweist:
   - Gesamtrauhigkeit (Höhe Spitze/Tal) $Rt \leqq 3 \ \mu m$,
   - Dichte der Spitzen, ausgedrückt im Verhältnis $Rt/Ra \leqq 10$ (Ra ist die mittlere arithmetische Rauhigkeit), und 5 bis 35 Gew.-% Einsatzstoffe aufweist. die folgende Charakteristiken besitzen:
   - mittlerer Durchmesser D50 1,5 bis 2,5 $\mu m$,
   - Monodispersität : $I \leqq 1,2$.

2. Semikristalline, biorientierte Polyesterfilm-Komposite nach Anspruch 1, dadurch gekennzeichnet, daß der Einsatzstoff aus im wesentlichen kugelförmigen Metalloxid-Teilchen besteht.

3. Semikristalline, biorientierte Polyesterfilm-Komposite nach einem der Ansprüche 1 bis 2, dadurch gekennzeichnet, daß die Schicht (B) eine geringere Dicke aufweist als der mittlere Durchmesser der Teilchen ausmacht, die sie als Einsatzstoff enthält.

4. Semikristalline, biorientierte Polyesterfilm-Komposite nach einem der Anspruche 1 bis 3, dadurch gekennzeichnet, daß der Einsatzstoff Kieselerde ist.

5. Semikristalline, biorientierte Polyesterfilm-Komposite nach Anspruch 4, dadurch gekennzeichnet, daß die Menge der Einsatzstoffe zwischen 5 und 15 Gew.-% in bezug auf den Polyester beträgt, der die Schicht (B) bildet.

6. Verwendung der semikristallinen, biorientierten Polyesterfilm-Komposite nach einem der Ansprüche 1 bis 5 als Schutzfolien für die photopolymerisierbare Schicht eines photopolymerisierbaren Elementes für Druckplatten.

7. Photopolymerisierbare Elemente für Druckplatten. bestehend aus mindestens einer Einheit, die im wesentlichen einen Träger, eine photopolymerisierbare Schicht und eine Schutzfolie umfaßt, dadurch gekennzeichnet, daß die genannte Schutzfolie aus einem koextrudierten, biorientierten Polyesterfilm-Komposit nach einem der Ansprüche 1 bis 5 besteht.

8. Photopolymerisierbare Elemente nach Anspruch 7, enthaltend zwei Einheiten. die im wesentlichen jeweils einen Träger und eine photopolymerisierbare Schicht umfassen, dadurch gekennzeichnet, daß die zwei photopolymerisierbaren Schichten durch eine Schutzfolie getrennt sind, die aus einem semikristallinen, biorientierten Polyesterfilm-Komposit nach einem der Ansprüche 1 bis 5 besteht, der eine Schicht (B) an jeder Fläche der Schicht (A) umfaßt.

9. Photopolymerisierbare Elemente nach Anspruch 8, bestehend aus einer Vielzahl von Einheiten, die jeweils einen Träger, eine photopolymerisierbare Schicht und eine Schutzfolie umfassen, dadurch gekennzeichnet, daß die photopolymerisierbare Schicht des Elementes von der angrenzenden photopolymerisierbaren Schicht durch einen Polyesterfilm-Komposit nach einem der Ansprüche 1 bis 5 getrennt ist, der eine Schicht (B) an nur einer der Flächen der Schicht (A) umfaßt.

10. Photopolymerisierbare Elemente nach Anspruch 9, dadurch gekennzeichnet, daß die Fläche der Schicht (A), die von der Schicht (B) befreit ist, eine Abdeckschicht umfaßt, die ihrerseits die Haftung an der photopolymerisierbaren Schicht unterstützt.


## Claims

1. Semicrystalline biaxially oriented composite polyester films comprising a filled or unfilled thick polyester layer (A) and, on at least one of the faces of the layer (A), a coextruded polyester layer (B) of lower thickness than that of the layer (A), which are characterised in that the layer (B) exhibits the following surface characteristics:
   - total roughness (peak/valley height) $Rt \leqq 3\ \mu m$
   - density of peaks, expressed as the ratio $Rt/Ra \leqq 10$ (Ra being the arithmetic mean roughness) and contains from 5 to 35 % by weight of a filler exhibiting the following characteristics:
   - mean diameter D50 of 1.5 to 2.5 $\mu m$
   - monodispersity : $I \leqq 1.2$.

2. Semicrystalline biaxially oriented composite polyester films according to Claim 1, characterised in that the filler consists of substantially spherical particles of metal oxides.

3. Semicrystalline biaxially oriented composite polyester films according to either of Claims 1 and 2, characterised in that the layer (B) has a thickness lower than the mean diameter of the particles of the filler which it contains.

4. Semicrystalline biaxially oriented composite polyester films according to any one of Claims 1 to 3, characterised in that the filler is silica.

5. Semicrystalline biaxially oriented composite polyester films according to Claim 4, characterised in that the quantity of filler is between 5 and 15 % by weight of the polyester forming the layer (B).

6. Use of the semicrystalline biaxially oriented composite polyester films according to any one of Claims 1 to 5 as sheets for protecting the photopolymerisable layer of a photopolymerisable component for a printing plate.

7. Photopolymerisable components for a printing plate, consisting of at least one combination comprising essentially a substrate, a photopolymerisable layer and a protective film, which are characterised in that the said protective film consists of a coextruded biaxially oriented composite polyester film according to any one of Claims 1 to 5.

8. Photopolymerisable components according to Claim 7, comprising two combinations, each essentially comprising a substrate and a photopolymerisable layer, characterised in that the two photopolymerisable layers are separated by a protective sheet consisting of a semicrystalline biaxially oriented composite polyester film according to any one of Claims 1 to 5 and comprising a layer (B) on each face of the layer (A).

9. Photopolymerisable components according to Claim 8, consisting of a plurality of combinations, each comprising a substrate, a photopolymerisable layer and a protective sheet, characterised in that each polymerisable layer of the component is separated from the adjacent photopolymerisable layer by a composite polyester film according to any one of Claims 1 to 5, comprising a layer (B) on only one of the faces of the layer (A).

10. Photopolymerisable components according to Claim 9, characterised in that the face of the layer (A) which is free from layer (B) comprises a layer of a coating promoting good adhesion to the photopolymerisable layer.